(19) Europäisches Patentamt
European Patent Office
Office européen des brevets

(11) **EP 2 734 851 B1**

(12) **FASCICULE DE BREVET EUROPEEN**

(45) Date de publication et mention
de la délivrance du brevet:
**11.05.2016 Bulletin 2016/19**

(21) Numéro de dépôt: **12735901.6**

(22) Date de dépôt: **19.07.2012**

(51) Int Cl.:
**G01R 29/08** *(2006.01)*     **G01R 31/00** *(2006.01)*
**H01Q 17/00** *(2006.01)*

(86) Numéro de dépôt international:
**PCT/EP2012/064231**

(87) Numéro de publication internationale:
**WO 2013/014065 (31.01.2013 Gazette 2013/05)**

(54) **DISPOSITIF DE CALIBRATION ET DE TEST POUR UNE ANTENNE ACTIVE NOTAMMENT UNE ANTENNE DE POINTE AVANT D'UN RADAR AEROPORTE**

KALIBRIERUNG UND TESTVORRICHTUNG FÜR EINE AKTIVE ANTENNE, INSBESONDERE EINER NASENKONUSANTENNE EINES BORDRADARS

CALIBRATION AND TESTING DEVICE FOR AN ACTIVE ANTENNA, PARTICULARLY A NOSE-CONE ANTENNA OF AN AIRBORNE RADAR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.07.2011   FR 1102291**

(43) Date de publication de la demande:
**28.05.2014   Bulletin 2014/22**

(73) Titulaire: **THALES**
**92200 Neuilly-sur-Seine (FR)**

(72) Inventeurs:
• **ESTEBE, Eric**
**F-75015 Paris (FR)**
• **LEVY, Pierre**
**F-78000 Versailles (FR)**
• **BOUEDO, Alain**
**F-78330 Fontenay-le-Fleury (FR)**

(74) Mandataire: **Derval, Estelle et al**
**Marks & Clerk France**
**Conseils en Propriete Industrielle**
**Immeuble Visium**
**22, avenue Aristide Briand**
**94117 Arcueil Cedex (FR)**

(56) Documents cités:
**EP-A1- 0 629 865     FR-A1- 2 434 497**
**US-A- 5 117 230**

• **ALI E F: "Electronic warfare testing at the Benefield anechoic facility", AUTOTESTCON, 97. 1997 IEEE AUTOTESTCON PROCEEDINGS ANAHEIM, CA, USA 22-25 SEPT. 1997, NEW YORK, NY, USA,IEEE, US, 22 septembre 1997 (1997-09-22), pages 232-243, XP010253024, DOI: 10.1109/AUTEST.1997.633617 ISBN: 978-0-7803-4162-3**

EP 2 734 851 B1

**Description**

L'invention concerne le domaine général du test de bon fonctionnement et de la calibration des antennes actives. Elle traite plus particulièrement des opérations de test de bon fonctionnement et de calibration exécutés hors processus de fabrication. Ces opérations peuvent être réalisées après montage de l'antenne sur l'équipement qui utilise cette antenne, ou encore dans un processus de vérification sur site après réparation de l'antenne, en particulier en cas d'échange d'un ou plusieurs des éléments (ou sous-réseaux) actifs qui la constituent.

Dans le processus de fabrication d'une antenne active, le test de bon fonctionnement de l'antenne ainsi que sa calibration représentent généralement des opérations finales. Ce sont des opérations relativement complexes qui nécessitent parfois la mise en oeuvre de moyens importants du fait de la taille de l'antenne fabriquée et de la densité des éléments actifs à la surface de l'antenne.

De manière connue, on utilise généralement des moyens formant une base de mesures, moyens qui permettent de réaliser soit des test en champ proche, compte tenu de la distance à laquelle est effectuée la mesure, soit des test en champ lointain à une distance de l'antenne telle que le diagramme de rayonnement de l'antenne est formé.

Les opérations de test et de calibration réalisées en champ proche, c'est-à-dire dans une zone où le diagramme d'antenne n'est pas encore formé, requièrent généralement l'installation de l'antenne dans une enceinte, un chambre anéchoïque, de façon que les signaux de test reçus par l'antenne ne soient pas altérés par des signaux parasites provenant notamment de la réflexion des signaux émis par le système de test sur des structures environnant l'antenne sous test.

Les moyens utilisés pour réaliser les tests de bon fonctionnement et la calibration d'une antenne en phase de réalisation comportent généralement, outre l'enceinte anéchoïque évoquée précédemment, des moyens pour générer et rayonner des signaux de test particuliers permettant de tester le fonctionnement unitaire ou en groupe des différents éléments actifs constituant l'antenne, ainsi que le fonctionnement global de l'antenne dans les différents modes de fonctionnement prévus. Ils comportent en outre des moyens de mesure qui permettent de comparer les caractéristiques du signal réellement reçu par l'antenne à celles attendues. Ce sont donc des moyens conséquents, performants et nécessairement centralisés en un lieu donné.

Par suite lors du dépannage d'une antenne sur un site d'exploitation on dispose rarement de tels équipements, de sorte que le test de bon fonctionnement et la calibration d'une antenne après une opération de maintenance sont généralement plus sommaires que ceux réalisés en usine, faute de pouvoir déployer dans chaque atelier de maintenance les moyens appropriés.

Pour pallier ce manque relatif de moyens il est possible de mettre en oeuvre différentes solution connues.

Une première solution consiste, après réparation, à faire effectuer le test et la calibration de l'antenne par une structure centralisée ayant les moyens appropriés, l'usine de production par exemple. Cependant, une telle façon de procéder induit des coûts de transport non négligeables, surtout pour des antennes de grande taille, et augmente le temps d'immobilisation de l'équipement. C'est pourquoi l'adoption d'une telle manière de procéder s'accompagne généralement d'un espacement dans le temps des opérations de maintenance, les antennes considérées étant, par exemple, conçues pour fonctionner dans un état dégradé pour lequel certains éléments actifs sont en panne.

Une autre solution consiste, après exécution d'opérations de maintenance, à réaliser seulement des tests simples et d'extrapoler l'état de fonctionnement et la calibration de l'antenne à partir des résultats de ces tests. Cependant, une telle façon de procéder ne permet pas toujours, en cas de défaillance constatée à un test, de distinguer la cause précise du dysfonctionnement enregistré (i.e. l'élément défaillant à l'origine d'un test erroné) de sorte qu'il est parfois nécessaire, dans le doute, de remplacer plusieurs éléments de l'antenne pour être sûr de remédier au problème à l'origine du test non réussi.

Le document FR 2 434 497 décrit une lentille diélectrique procédé de contrôle de dispositifs électromagnétiques utilisant cette lentille et appareil pour la mise en oeuvre du procédé.

Un but de l'invention est de proposer un système de test permettant de réaliser sur site les tests de bon fonctionnement et les opérations de calibration d'une antenne active, en particulier d'une antenne active du type de celles qui équipent les radars de pointe avant, montés sur des aéronefs.

Un autre but de l'invention est de proposer une solution permettant d'utiliser les moyens du radar sur lequel est montée l'antenne comme moyens de générer un signal de test et de réaliser les mesures appropriées, ou bien l'antenne elle-même, si elle dispose de fonctions de génération et de réception de signal ainsi que de fonctions de mesure de l'amplitude et de la phase du signal reçu.

L'invention est définie par l'objet des revendications 1, 2 et 8.

A cet effet l'invention a pour objet un dispositif de test et de calibration pour antenne active, comportant une pluralité d'éléments actifs d'émission-réception agencés de façon à former une surface rayonnante. Ledit dispositif comporte:

- une enceinte de mesure configurée pour être montée en regard de la face rayonnante de l'antenne sur la structure supportant l'antenne et dans laquelle est positionnée une sonde de test apte à capter et à rayonner des signaux électromagnétiques hyperfréquence,

- des moyens pour générer un signal radioélectrique hyperfréquence de test ainsi que des moyens pour effectuer la réception d'un signal radioélectrique hyperfréquence et effectuer une mesure vectorielle du signal reçu.

Le dispositif selon l'invention est caractérisé en ce que l'enceinte de mesure comporte elle-même:

- une paroi formant une cavité pourvue d'une ouverture, l'ouverture étant configurée de façon à ce que la cavité soit obturée par la face rayonnante de l'antenne lorsque l'enceinte est montée sur la structure supportant l'antenne;
- des moyens permettant de positionner la sonde de test à l'intérieur de la cavité dans une position donnée;
- des moyens de fixation permettant de réaliser le montage de l'enceinte de mesure sur la structure supportant l'antenne, ces moyens étant configurés de façon à assurer, après montage, un positionnement axial connu de l'enceinte de mesure par rapport à la face rayonnante de l'antenne;

Selon l'invention, la paroi formant la cavité est revêtue sur sa face interne d'éléments absorbant les ondes radioélectriques. Sa face externe est en outre configurée pour former un blindage électrique.

Selon un mode de réalisation particulier du dispositif selon l'invention adapté au test d'une antenne active radar montée à l'avant d'un aéronef et placée sous la coiffe formant la pointe avant dudit aéronef, les moyens de fixation de l'enceinte de mesure sont identiques aux moyens permettant de fixer la coiffe sur la structure avant de l'aéronef qui supporte l'antenne.

Selon un mode de réalisation particulier du dispositif selon l'invention, la profondeur de la cavité définie par l'enceinte de mesure est déterminée de façon à permettre une mesure en champ intermédiaire ou lointain du signal reçu par la sonde de test lorsqu'un ou plusieurs éléments actifs de l'antenne sont en émission, compte tenu de la position de la sonde de test dans la cavité.

Selon l'invention, les dimensions de l'enceinte de mesure sont déterminées de façon à ce que, compte tenu de la position de la sonde dans la cavité, la distance de la sonde à chacun des éléments actifs constituant l'antenne soit supérieure à $d^2/2 \cdot \lambda$, d représentant la taille de l'ouverture rayonnante équivalente d'un élément actif de l'antenne ou d'un sous-réseau constitué d'éléments actifs.

Selon l'invention, l'enceinte de mesure est configurée de façon à définir une cavité dont les dimensions permettent de positionner la sonde de test à une position fixe pour laquelle elle couvre la totalité de la surface active de l'antenne et pour laquelle elle est éclairée par le lobe principal du diagramme de rayonnement de chacun des éléments actifs constituant l'antenne.

Selon l'invention, compte tenu de la profondeur D2 de la cavité définie par l'enceinte de mesure et des dimensions du diagramme de la sonde de test utilisée, l'enceinte de mesure comporte une pluralité de sondes de test. Chaque sonde est montée sur un moyen permettant de la positionner à l'intérieur de la cavité dans une position connue. Le nombre de sondes de test et la position de chacune de ces sondes sont définis de façon à ce que la réunion de leurs diagrammes de rayonnement couvre la totalité de la surface active de l'antenne et que chacune des sondes soit éclairée par le lobe principal du diagramme de rayonnement d'un ou plusieurs éléments actifs, ou sous-réseaux actifs, constituant l'antenne.

Selon l'invention, compte tenu de la profondeur D2 de la cavité définie par l'enceinte de mesure et des dimensions du diagramme de la sonde de test utilisée, la sonde de test est montée sur des moyens de positionnement configurés de façon à permettre le positionnement de la sonde de test à différentes positions à l'intérieur de la cavité. Ces positions sont déterminées de façon à ce que, pour chaque position, la sonde de test soit éclairée par le lobe principal du diagramme de rayonnement d'un ou plusieurs éléments actifs, ou sous-réseaux actifs, constituant l'antenne et que l'ensemble des positions permette à la sonde de couvrir l'ensemble de éléments actifs, ou des sous-réseaux actifs, constituant l'antenne.

Selon une forme particulière du mode de réalisation précédent, les moyens permettant de positionner la sonde de test à l'intérieur de la cavité sont configurés de façon à ce que lorsque l'enceinte de mesure est fixée sur la structure supportant l'antenne la distance séparant une sonde de test de chacun des éléments de l'antenne qu'elle couvre diffère, d'une valeur théorique donnée, d'un écart inférieur à l'écart ΔL défini par:

$$\Delta L = (\Delta \varphi \cdot \lambda)/360$$

Où $\Delta \varphi$ représente l'erreur de phase systématique exprimée en degrés.

Dans un mode particulier de réalisation, les moyens pour générer un signal radioélectrique hyperfréquence de test et les moyens pour effectuer la réception d'un signal radioélectrique hyper fréquence et effectuer une mesure vectorielle du signal reçu sont constitués par l'équipement radar associé à l'antenne testée.

Comme le dispositif ne nécessite pas de démonter l'antenne du radar, il n'est donc pas non plus nécessaire d'utiliser des moyens de génération/réception externes puisque ceux du radar peuvent être utilisés et sont naturellement présents. Cela entraîne un gain de temps et de place. Par ailleurs, les mesures étant faites avec les moyens du radar, la calibration réalisée intègre également les défauts de la chaîne du radar (et il y en a forcément) ce qui permet d'améliorer la performance du système global.

L'invention a également pour objet un système de test comprenant un radar équipé d'une antenne active et un dispositif de test et de calibration selon l'une quelconque des revendications précédentes.

Dans un mode particulier de réalisation, l'enceinte est constituée d'une paroi périphérique, définissant une cavité, l'enceinte comportant une ouverture présentant des dimensions suffisantes pour que la face active de l'antenne puisse être placée à l'entrée de la cavité sans qu'aucun obstacle matériel ne soit placé entre face active de l'antenne et l'intérieur de la cavité et dans lequel l'enceinte est agencée de manière à pouvoir englober la totalité de l'antenne de façon que l'antenne (19) ferme l'ouverture.

L'invention a également pour objet un procédé pour réaliser le test d'une antenne active en émission ou en réception au moyen du dispositif selon l'invention, dans lequel les moyens pour générer un signal radioélectrique hyperfréquence de test et les moyens pour effectuer la réception d'un signal radioélectrique hyper fréquence et effectuer une mesure vectorielle du signal reçu étant constitués par l'équipement radar associé à l'antenne testée dans lequel :

- on produit un signal de test hyperfréquence qui est rayonné à l'intérieur de l'enceinte de mesure au moyen de la chaine d'émission du radar ou de l'antenne sous-test
- on effectue au moyen de la chaine de réception du radar, la réception et la démodulation du signal capté par des moyens de réception,
- on numérise le signal capté par l'antenne sous-test au moyen des moyens de traitement du signal du radar ou de l'antenne sous-test,

L'invention a également pour objet un premier procédé pour réaliser le test d'une antenne active en émission au moyen du dispositif selon l'invention, les moyens nécessaires pour générer un signal radioélectrique hyperfréquence de test et les moyens nécessaires pour effectuer la réception d'un signal radioélectrique hyper fréquence et effectuer une mesure vectorielle du signal reçu étant fournis par l'équipement radar associé à l'antenne testée. Selon ce procédé:

- on produit un signal de test hyperfréquence et un signal de référence au moyen de la chaine d'émission du radar. Le signal de test est ensuite rayonné à l'intérieur de l'enceinte de mesure, via l'antenne sous test;
- on effectue séparément, au moyen de la chaine de réception du radar, la réception et la démodulation du signal capté par la sonde de test d'une part et du signal de référence d'autre part;
- on mesure l'amplitude et la phase relatives du signal capté par l'antenne sous test par rapport à l'amplitude et à la phase du signal de référence. Cette amplitude et cette phase relative sont déterminées, après numérisation des deux signaux, par les moyens de traitement du signal du radar et comparées à des valeurs théoriques de référence.

L'invention a également pour objet un procédé pour réaliser le test d'une antenne active en réception au moyen du dispositif selon l'invention, les moyens pour générer un signal radioélectrique hyperfréquence de test et les moyens pour effectuer la réception d'un signal radioélectrique hyper fréquence et effectuer une mesure vectorielle du signal reçu étant constitués par l'équipement radar associé à l'antenne testée.

Selon ce procédé:

- on produit un signal de test hyperfréquence au moyen de la chaine d'émission du radar. Le signal de test est ensuite rayonné à l'intérieur de l'enceinte de mesure, via la sonde de test;
- on effectue séparément, au moyen de la chaine de réception du radar la réception et la démodulation du signal capté par l'antenne sous test d'une part et du signal capté par une antenne auxiliaire solidaire de l'antenne sous test, ce dernier signal étant considéré comme signal de référence;
- on mesure l'amplitude et la phase relatives du signal capté par l'antenne sous test par rapport à l'amplitude et à la phase du signal de référence. Cette amplitude et cette phase relative sont déterminées, après numérisation des deux signaux, par les moyens de traitement du signal du radar et comparées à des valeurs théoriques de référence.

L'invention a également pour objet un second procédé pour réaliser le d'une antenne active en émission au moyen du dispositif selon l'invention, les moyens pour générer un signal radioélectrique hyperfréquence de test et les moyens pour effectuer la réception d'un signal radioélectrique hyper fréquence et effectuer une mesure vectorielle du signal reçu étant constitués par l'équipement radar associé à l'antenne testée. Selon ce procédé:

- on produit un signal de test hyperfréquence et un signal de référence au moyen de la chaine d'émission du radar. Le signal de test est rayonné à l'intérieur de l'enceinte de mesure, via l'antenne sous test. Le signal de test rayonné est obtenu par transposition d'un signal de test en fréquence intermédiaire dont la fréquence est déduite, par multiplication de fréquence, d'une horloge de référence qui sert également de référence pour les moyens de traitement du signal du radar;
- on effectue au moyen de la chaine de réception du radar la réception et la démodulation du signal capté par la sonde de test;
- on mesure l'écart d'amplitude et de phase du signal capté par l'antenne sous test par rapport à l'horloge de référence, l'amplitude et la phase du signal capté étant déterminées, après numérisation, par le moyens de traitement du signal du radar et comparées à des valeurs théoriques de référence.

L'invention a encore pour objet un procédé pour réaliser le test d'une antenne active en réception au moyen du dispositif selon l'invention, les moyens pour générer un signal radioélectrique hyperfréquence de test et les moyens pour effectuer la réception d'un signal radioélectrique hyper fréquence et effectuer une mesure vectorielle du signal reçu étant constitués par l'équipement radar associé à l'antenne testée. Selon ce procédé:

- on produit un signal de test hyperfréquence et un signal de référence au moyen de la chaine d'émission du radar. Le signal de test est rayonné à l'intérieur de l'enceinte de mesure, via la sonde de test. Le signal de test rayonné est obtenu par transposition d'un signal de test en fréquence intermédiaire dont la fréquence est déduite, par multiplication de fréquence, d'une horloge de référence qui sert également de référence pour les moyens de traitement du signal du radar;
- on effectue au moyen de la chaine de réception du radar la réception et la démodulation du signal capté par l'antenne sous test;
- on mesure l'écart d'amplitude et de phase du signal capté par l'antenne sous test par rapport à l'horloge de référence. L'amplitude et la phase du signal mesuré sont déterminées, après numérisation, par le moyens de traitement du signal du radar et comparées à des valeurs théoriques de référence.

Les caractéristiques et avantages de l'invention seront mieux appréciés grâce à la description qui suit, description qui s'appuie sur les figures annexées qui représentent:

- la figure 1, une illustration schématique représentant la structure et la composition de l'enceinte du dispositif selon l'invention;
- la figure 2, une illustration schématique d'une première variante de mise en oeuvre de l'invention;
- la figure 3, une illustration schématique présentant un premier mode de réalisation des moyens permettant de rayonner un signal de test et de capter les signaux émis par les différents éléments de l'antenne ;
- la figure 4, une illustration schématique présentant un deuxième mode de réalisation des moyens permettant de rayonner un signal de test et de capter les signaux émis par les différents éléments de l'antenne ;
- les figures 5 et 6, des illustrations schématiques présentant un troisième mode de réalisation des moyens permettant de rayonner un signal de test et de capter les signaux émis par les différents éléments de l'antenne;

- la figure 7, un schéma synoptique décrivant les moyens associés à l'enceinte de mesure pour réaliser les tests de bon fonctionnement et de calibration de l'antenne en émission ou en réception;
- la figure 8, un schéma synoptique d'une mesure en émission par rapport à une voie de référence;
- la figure 9, un schéma synoptique d'une mesure en réception par rapport à une voie de référence qui peut être soit la voie auxiliaire de l'antenne soit un couplage du signal de test;
- la figure 10, un schéma synoptique d'une mesure en émission utilisant le signal doppler, synchrone de la période de mesure, de façon à s'affranchir d'une voie de référence;
- la figure 11, un schéma synoptique d'une mesure en réception utilisant le signal doppler, synchrone de la période de mesure, de façon à s'affranchir d'une voie de référence.

Le système selon l'invention est décrit dans la suite du document au travers de son application au test et à la calibration d'antennes actives à balayage électronique pour radar de pointe avant d'aéronef, auxquels il est particulièrement adapté. Cependant cette application particulière est présentée ici au titre d'exemple de réalisation non limitatif de la portée de l'invention.

De manière générale, une antenne active à balayage électronique est une antenne réseau qui comporte des dispositifs électroniques permettant des changements dans la forme et la direction du faisceau émis (et du faisceau reçu). Selon leur nature, ces dispositifs électroniques (déphaseurs, commutateurs, filtres) qui sont connectés aux éléments rayonnants, agissent sur la forme, la direction, la fréquence ou la polarisation de l'onde électromagnétique rayonnée. De telles antennes qui peuvent présenter des structures variées, sont cependant classées, de manière connue, en deux grandes familles: les antennes dites passives et les antennes dites actives.

Une antenne à balayage électronique active est une antenne dont la structure inclut, de manière connue, des dispositifs d'amplification des signaux émis ou reçus. Une telle antenne forme un réseau de voies élémentaires actives d'émission et de réception, qui peuvent être combinées de différentes façons. Accessoirement sa structure peut également intégrer des dispositifs électroniques réalisant des fonctions classiques comme la transposition de fréquence ou le codage numérique des signaux.

Le réglage et la vérification du bon fonctionnement des antennes actives incluent en général une phase dite de calibration.

La calibration consiste d'abord à mesurer sur l'antenne assemblée les dispersions d'amplitude et de phase en émission ou réception enregistrées sur les différentes voies élémentaires de l'antenne, ces dispersions étant notamment dues aux dispersions des composants formant ces voies actives élémentaires ainsi qu'aux dispersions d'assemblage. Elle consiste ensuite à déterminer les corrections adéquates d'amplitude et de phase à appliquer aux différentes voies active élémentaires pour compenser ces dispersions.

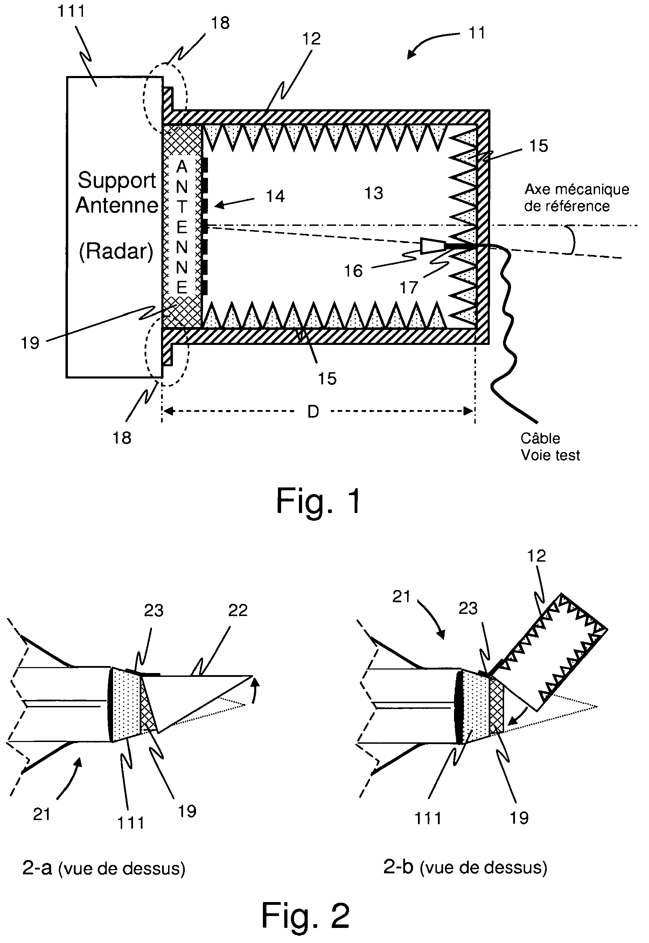

Pour réaliser l'opération de calibration d'une antenne active le système de test selon l'invention comporte, comme l'illustre la figure 1, une enceinte de test 11 qui selon les cas d'utilisation peuvent être associés à différents types de moyens complémentaires. Ces moyens complémentaires ont pour fonction de générer un signal de test. Ce signal de test est émis, selon les cas, soit par un élément rayonnant placé dans l'enceinte à proximité de l'antenne et indépendant de l'antenne, celle-ci étant alors testée en réception, soit par l'antenne elle-même, celle-ci étant alors testée en émission. Ces moyens complémentaires ont également pour fonction de réaliser la réception et le traitement des signaux reçus, soit par un capteur indépendant de l'antenne placé dans l'enceinte à proximité de l'antenne et indépendant de l'antenne, celle-ci étant alors testée en émission soit par l'antenne elle-même, celle-ci étant alors testée en réception.

A cet effet, l'enceinte 11 est constituée d'une paroi périphérique 12, définissant une cavité 13. Selon l'invention, l'enceinte 11 comporte une ouverture de dimensions suffisantes pour que la face active 14 de l'antenne puisse être placée à l'entrée de la cavité sans qu'aucun obstacle matériel ne soit placé entre face active de l'antenne et l'intérieur de la cavité 13. Avantageusement, l'enceinte est agencée de manière à pouvoir englober la totalité de l'antenne 19 l'antenne 19 de façon que ferme l'ouverture 19 comme cela est représenté sur la figure 1. Cela permet d'éviter les pertes de rayonnement lors du test ainsi que les perturbations extérieures. Cela protège également les opérateurs des fuites extérieures.

Comme l'illustre la figure 1, la face interne de la paroi 12 de l'enceinte 11 est revêtue d'une structure 15 absorbant les rayonnements électromagnétiques qui la percutent. De la sorte, avantageusement, seuls les rayonnements directs sont considérés.

L'enceinte 11 comporte également un élément rayonnant 16 monté dans la cavité 13 par l'intermédiaire d'un support 17. Cet élément rayonnant 16 constitue une sonde de test permettant soit d'émettre un signal en direction de l'antenne 19, soit de recevoir le signal émis depuis l'antenne 19. Cet élément rayonnant peut par exemple consister en un cornet ou en tout autre dispositif rayonnant réciproque.

Selon un mode de réalisation préféré de l'invention, l'enceinte 11 est configurée de façon à pouvoir être positionnée de manière automatique dans une position relative fixe, connue, par rapport à l'antenne. De la sorte, dans la mesure où la position de la sonde dans l'enceinte 11 est connue, le positionnement fixe connu de l'enceinte par rapport à l'antenne permet de connaitre à tout instant la position de la sonde 16 par rapport au plan de l'antenne 14 en regard de la cavité 13. A cet effet l'enceinte 11 comporte des moyens permettant de réaliser son montage dans une position précise sur la structure qui supporte l'antenne durant les essais pratiqués.

Les illustrations 2-a et 2-b de la figure 2 présentent des vues schématique (vues de dessus) d'un mode de réalisation particulier de l'enceinte selon l'invention, adapté au test d'une antenne 19 équipant un radar 111 de pointe avant d'un aéronef 21. L'enceinte 11 est ici préférentiellement équipée de moyens de fixation identiques à ceux 23 permettant de fixer la coiffe 22, le radôme, constituant le nez de l'aéronef 21 sur la structure supportant le radar et l'antenne au niveau de l'aéronef. De la sorte, les moyens servant au support du radar et de l'antenne lors des opérations de maintenance en atelier étant généralement pourvus de ces mêmes moyens de fixation de façon à pouvoir réaliser des essais du radar intégrant la coiffe, l'enceinte selon l'invention permet avantageusement de réaliser des tests sur l'antenne aussi bien lorsqu'elle est montée sur un support de maintenance en atelier que lorsqu'elle est encore (ou de nouveau) montée sur avion.

Alternativement, en l'absence des moyens de fixation décrits précédemment, l'enceinte peut être associée à tous moyens permettant de positionner l'enceinte, et par conséquent la sonde 16, en regard de l'antenne 19, dans une position position et une orientation connue par rapport au plan de l'antenne.

Selon l'invention, la sonde 16 est positionnée dans la cavité 13 de façon à occuper une position connue par rapport au plan de l'antenne 19 lorsque l'enceinte 11 est correctement positionnée. Le positionnement de la sonde est assuré par des moyens propres à garantir la précision de positionnement requise pour permettre la réalisation des tests de bon fonctionnement des éléments de l'antenne ainsi que la calibration angulaire de cette dernière.

On rappelle à cette occasion que la précision de calibration en amplitude et phase d'une antenne constituée d'éléments rayonnants est directement liée à la connaissance préalable de la fonction de transfert entre différents éléments rayonnants, pris séparément ou constitués en sous-réseaux et la sonde, cette fonction de transfert pouvant être déterminée de manière théorique, par des simulations électromagnétiques, ou bien expérimentalement. Elle est également fonction de la précision des mesures d'amplitude et de phase réalisées lors de la calibration.

Or, la maitrise de ces fonctions de transfert pour une position donnée de la sonde 16 par rapport au plan d'antenne 14, impose certaines contraintes.

Il est ainsi préférable de positionner la sonde 16 dans la zone de champ intermédiaire ou lointain des éléments rayonnants ou des sous-réseaux regroupant ces éléments. Un tel éloignement permet en effet d'éviter les effets des variations trop rapides du champ rayonné en fonction de la position, effets que l'on rencontre dans le cas de mesures en zone proche. De la sorte, l'effet d'une légère erreur de positionnement de la sonde par rapport à la position prévue est avantageusement moins sensible.

Ainsi selon l'invention, la distance d entre chaque élément (ou sous-réseau) et la sonde est, typiquement, choisie supérieure à $D^2/(2 \cdot \lambda)$. D représente ici la valeur de l'ouverture rayonnante équivalente à l'élément (ou au sous-réseau) considéré et $\lambda$ la longueur d'onde moyenne de fonctionnement de l'antenne.

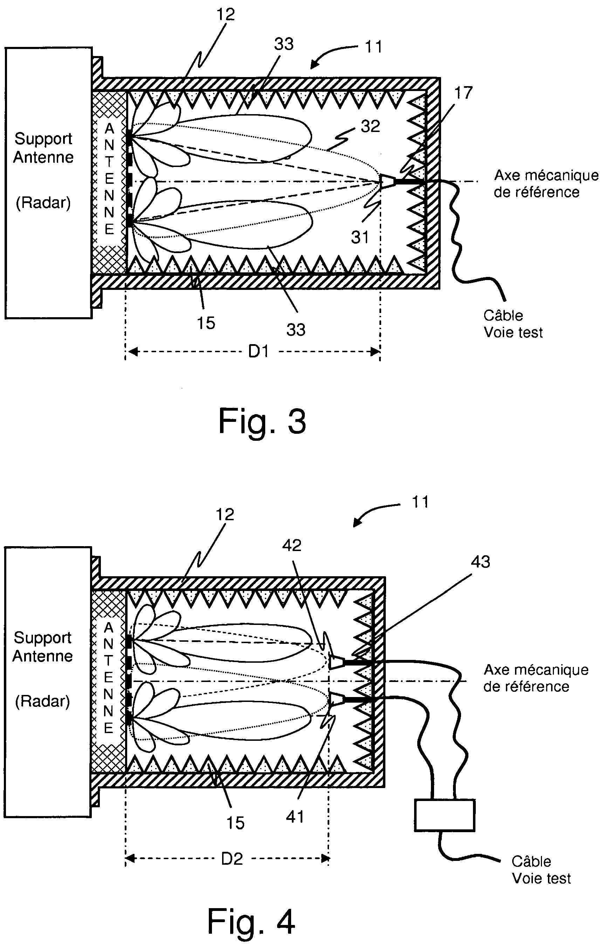

Comme l'illustre la figure 3, il est de même préférable, afin d'obtenir un niveau de fonction de transfert suffisant et prédictible, de positionner la sonde 16 de telle manière que son diagramme de rayonnement 31 intercepte le lobe principal 32 rayonné par chaque élément (ou sous-réseau).

De même encore, il est préférable d'utiliser une sonde dont le lobe principal 31 du diagramme de rayonnement intercepte l'ensemble de l'antenne pour la distance D1 considérée.

Alternativement, notamment dans le cas où l'antenne à tester est de grande taille, ou bien dans le cas où la profondeur de l'enceinte est plus restreinte ou encore dans le cas où le diagramme de rayonnement de la sonde 16 utilisée est plus restreint, il est possible, comme l'illustre la figure 4, de mettre en oeuvre plusieurs sondes positionnées en différents endroits, chaque sonde étant utilisée pour tester une portion donnée de l'antenne, c'est-à-dire une partie des éléments actifs constituant l'antenne. Dans ce cas les différentes sondes sont disposées, de préférence, dans un plan distant d'une distance D2 du plan de l'antenne, de façon à ce que chaque sous-ensemble d'éléments actifs formant une portion donnée de l'antenne soit couvert (i. e. éclairé) par le lobe principal 41 du diagramme de rayonnement d'au moins une des sondes et puisse, par suite, être testé au moyen de cette sonde.

Par ailleurs, dans la mesure où la fonction de transfert calculée correspond à une position donnée de la sonde considérée par rapport au plan d'antenne, l'obtention de mesures de calibration précises, requiert un positionnement précis de la sonde 16 à l'endroit pour lequel la fonction de transfert considérée a été déterminée. Typiquement, une précision de positionnement compatible de la précision des mesures d'amplitude - phase recherchée pour la calibration; est notamment obtenue si la différence $\delta d$, entre la distance réelle entre la sonde et l'élément d'antenne (ou le sous-réseau) considéré et la distance considérée pour déterminer la fonction de transfert, est inférieure au produit $(\Delta\varphi_{max} \, \lambda)/360$, où $\Delta\varphi_{max}$ représente l'erreur maximale autorisée sur la mesure de phase exprimée en degrés.

Concernant la précision des mesures de calibration, on rappelle également que la précision de calibration en amplitude et phase d'une antenne constituée d'éléments rayonnants détermine également la maitrise de la direction de pointage de l'antenne, l'axe antenne - sonde devant être maîtrisé avec une précision meilleure que la précision d'harmonisation angulaire recherchée pour l'antenne. On rappelle ici que la précision d'harmonisation angulaire correspond à la précision avec laquelle l'axe radioélectrique de l'antenne est confondu avec son axe mécanique.

Selon le mode de réalisation considéré différents moyens de positionnement sont mis en oeuvre.

Selon un premier mode de réalisation illustré par la figure 3, on met par exemple en oeuvre une sonde 31 présentant un diagramme de rayonnement 32 suffisamment large, non directif, pour que, compte tenu de la distance D1 séparant la sonde du plan de l'antenne, l'ensemble de la surface rayonnante de l'antenne 19 soit couverte par ce diagramme (i. e. éclairé) et que la sonde 31 soit éclairée par le lobe principal du diagramme de chaque sous-réseau ou de chaque élément rayonnant à tester.

Dans ce premier mode la sonde 31 est placée dans une position fixe à l'intérieur de la cavité 13. Pour ce faire elle est fixée à la paroi 12 de l'enceinte par l'intermédiaire d'un support rigide 17. Les dimensions de l'enceinte 12, la profondeur D1 en particulier, sont par ailleurs définies de telle façon que le lobe principal du diagramme de rayonnement 33 de chacun des éléments rayonnants constituant l'antenne englobe la position de la sonde. Le diagramme de rayonnement de la sonde 31 est quant à lui défini de façon à ce que celle-ci puisse éclairer l'ensemble des éléments actifs constituant l'antenne.

Dans ce mode de réalisation, le positionnement précis de la sonde 31 par rapport au plan de l'antenne 19 sous test, est ainsi avantageusement assuré d'une part par le lien fixe reliant la sonde 31 à l'enceinte 12 et d'autre part par le positionnement et l'orientation précis de l'enceinte par rapport à ce même plan d'antenne, positionnement et orientation garantis par l'utilisation des moyens de fixation décrits précédemment. Dans ce mode de réalisation particulier le positionnement de la sonde est en outre fixe.

Ce premier mode de réalisation, quoique avantageux, nécessite cependant de disposer d'une sonde positionnée de telle façon, que compte tenu de son diagramme de rayonnement, elle soit en mesure de couvrir, à elle seule, la surface rayonnante de l'antenne 19 et d'être éclairée par le lobe principal du diagramme de chaque sous-réseau ou de chaque élément rayonnant à tester. Cette condition nécessite en outre de disposer d'une enceinte d'une profondeur D suffisante. Or, cet ensemble de conditions n'est pas nécessairement simple remplir, de sorte que pour pallier les problèmes d'éclairement et de profondeur du dispositif, on est parfois amené à envisager des modes de réalisation alternatifs, tels que ceux décrits dans la suite du texte.

Selon un second mode de réalisation, illustré par la figure 4, on met par exemple en oeuvre une pluralité de sondes (deux sondes 41 et 42 sur l'illustration de la figure 4), Le nombre et les positions des sondes mises en oeuvre sont déterminés de façon à ce que chaque portion de la surface de l'antenne 19 soit couverte par le diagramme de rayonnement d'au moins une sonde et que le lobe principal du diagramme de chaque sous-réseau ou de chaque élément rayonnant à tester éclaire au moins une des sondes.

Dans ce second mode de réalisation chacune des sondes 41, 42 est placée dans une position fixe à l'intérieur de la cavité 13, à une distance D2 de la surface rayonnante de l'antenne. Pour ce faire elle est fixée à la paroi 12 de l'enceinte par l'intermédiaire d'un support rigide 43, du même type que le support 17 mentionné précédemment.

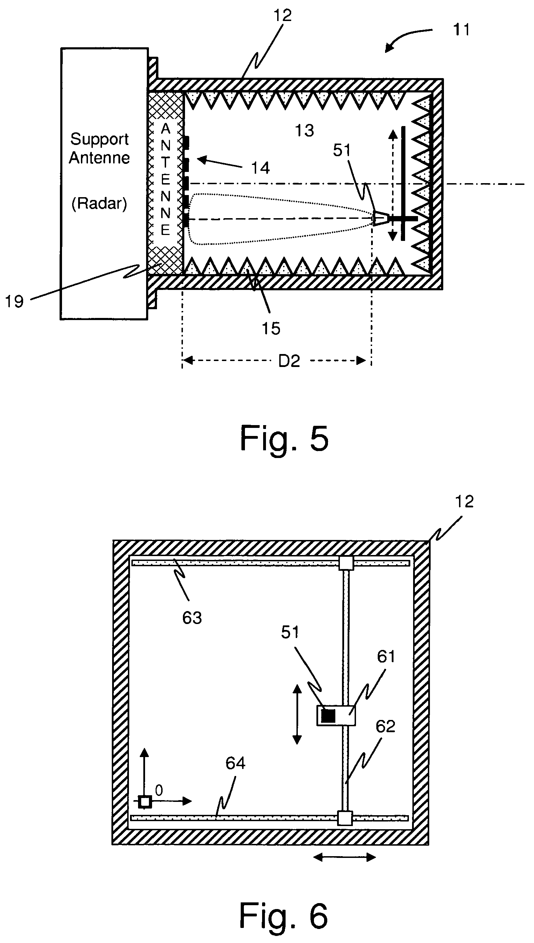

Selon un troisième mode de réalisation, on met par exemple en oeuvre, comme l'illustre la figure 5, une sonde unique 51 montée sur des moyens permettant de la faire se déplacer à l'intérieur de la cavité, dans un plan parallèle au plan de l'antenne, ou selon une direction donnée dans ce plan par exemple.

L'amplitude de déplacement est définie de façon à ce que, compte tenu des dimensions du diagramme de rayonnement de la sonde 51, les positions qu'elle peut occuper lui permettent de couvrir chaque portion de la surface de l'antenne 19 et d'être éclairée par le lobe principal du diagramme de rayonnement de chacun des sous-réseaux ou des éléments rayonnants à tester.

Les moyens de déplacements sont configurés de telle façon que la position précise de la sonde par rapport à un point de référence donné O, soit toujours connue, la position du point O de référence étant elle-même connue avec précision. La figure 6 illustre de manière schématique un exemple de réalisation de tels moyens, dans lequel la sonde 51 est montée sur un chariot 61, mobile en translation le long d'une tige guide 62 elle-même guidée en translation par deux glissières 63 et 64 dans une direction perpendiculaire à son axe. Les différents mouvements de translation sont imprimés par des moyens moteurs, non représentés sur la figure, configurés pour assurer contrôle précis du déplacement du chariot et du positionnement en x et en y du chariot 62, et donc de la sonde 51, par rapport au point de référence 0.

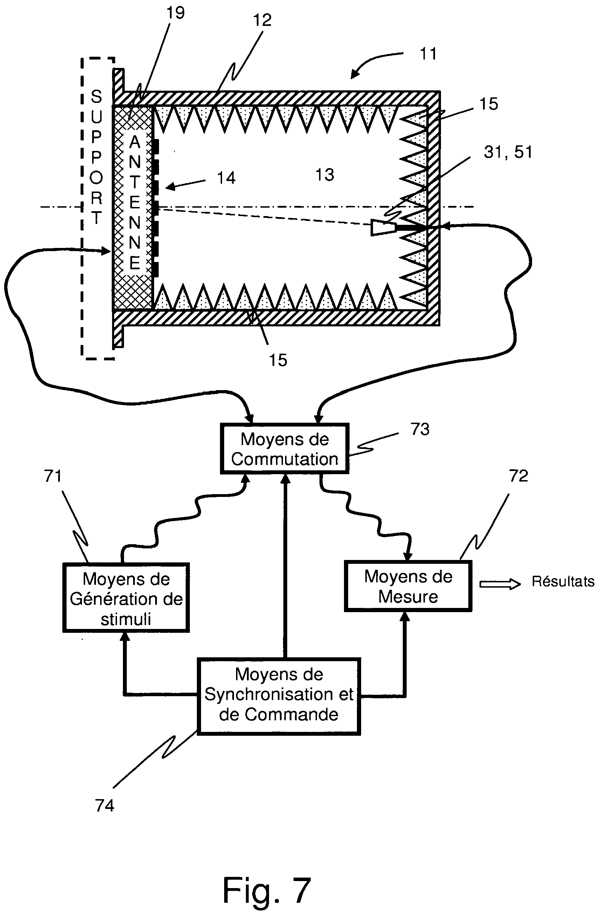

Selon l'invention, l'enceinte de test décrite dans le texte qui précède est associée, comme l'illustre le schéma de la figure 7, à des moyens de stimulation 71 et de mesure 72. Les moyens de stimulation 71 ont pour objet de générer un signal de test destiné à être émis soit par la sonde de test 31 (ou 51), ou les sondes de test 41 et 42, placées dans l'enceinte 11, de façon à réaliser le test de la fonction de réception de l'antenne 19, soit par l'antenne 19 elle-même, de façon à tester la fonction d'émission de l'antenne. Les moyens de mesure 72 ont, quant à eux, pour objet soit de réaliser la réception et la mesure du signal reçu par la sonde de test 31 (ou 51), ou les sondes de test 41 et 42, placées dans l'enceinte 11 lorsqu'on réalise le test de la fonction d'émission de l'antenne, soit de réaliser la réception et la mesure des signaux reçus par les éléments actifs constituant l'antenne lorsqu'on réalise le test de la fonction de réception de celle-ci.

Selon l'invention, la nature et la forme des signaux constituant les stimuli, de même que le traitement appliqué aux signaux reçus, dépendent principalement du test réalisé: test de bon fonctionnement d'un élément actif ou d'un groupe d'éléments actifs de l'antenne ou test de calibration, en émission ou en réception.

Par ailleurs, les moyens de stimulation 71 et les moyens de mesure 72 peuvent être constitués d'appareils spécifiquement conçus pour réaliser ces tests, y compris des moyens du commerce configurés de manière appropriée. Ils sont alors raccordés à l'antenne sous test et à la sonde de test 31 (51), ou aux sondes de test 41 et 42, à l'aide de moyens de commutation 73 et orchestrés par des moyens de synchronisation et de commande 74 appropriés. Le dispositif selon l'invention intègre alors ces moyens de stimulation et de mesure.

Alternativement, lorsque l'équipement radar associé à l'antenne testée 19 comporte une voie de test, les fonctions de stimulation et de mesure peuvent être réalisées en utilisant le radar lui-même.

Alternativement encore si l'antenne considérée comporte des moyens de génération et de réception de signal ainsi que des moyens de mesure de l'amplitude et de la phase du signal reçu, les fonctions de stimulation et de mesure peuvent être réalisées en utilisant l'antenne elle-même.

Dans un mode particulier de réalisation, les moyens pour générer un signal radioélectrique hyperfréquence de test et les moyens pour effectuer la réception d'un signal radioélectrique hyper fréquence et effectuer une mesure vectorielle du signal reçu sont constitués par l'équipement radar associé à l'antenne testée.

L'invention a également pour objet un système de test comprenant un radar 111 équipé d'une antenne active 19 et un dispositif de test et de calibration pour ladite antenne tel que décrit précédemment.

Dans la suite du texte on décrit deux méthodes, deux procédés, permettant de réaliser des mesures de calibration et de test au moyen de l'enceinte de mesure 11 selon l'invention et en mettant en oeuvre les moyens techniques du radar pour réaliser les fonctions de stimulation et de mesure. Le radar est ici supposé être un radar Doppler cohérent permettant de réaliser des mesures en amplitude et en phase du signal reçu.

Dans les deux procédés décrits, l'onde émise est générée par un synthétiseur de fréquences en moyenne fréquence puis transposée en hyperfréquence. Par ailleurs l'onde reçue est démodulée en bande de base par les oscillateurs locaux de transposition issus du synthétiseur. Les mesures sont effectuées en émission et en réception car la fonction de transfert est différente.

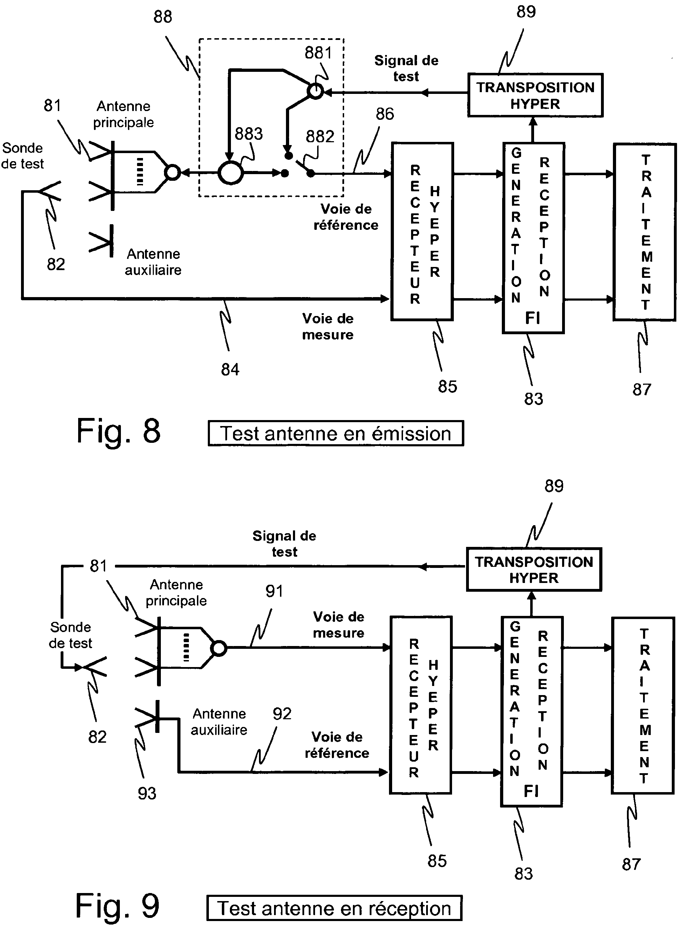

Le premier procédé est illustré par les figures 8 et 9. Il consiste, de manière classique, à comparer les signaux à mesurer à un signal de référence connu.

La figure 8 présente la configuration matérielle correspondant à l'utilisation des moyens techniques du radar dans le cadre du premier procédé, pour le test en émission d'un ou plusieurs éléments actifs de l'antenne, ce test pouvant évidemment couvrir le test d'un élément unique 81 aussi bien que celui de l'antenne complète 19.

Conformément à ce premier procédé, le signal issu du synthétiseur intégré aux moyens 83 de génération et de réception FI du radar est transposé en hyperfréquence et émis par les différents éléments rayonnants 81 sous test. Le signal rayonné est quant à lui prélevé par la sonde de test 82 de l'enceinte de mesure 11 selon l'invention et transmise au récepteur 85 du radar, via une première voie de réception 84 ou voie de mesure, en s'assurant de la maîtrise des découplages et des fuites possibles. La voie de mesure est soit la voie de réception principale de traitement du radar soit une voie de mesure d'écartométrie ou une autre voie auxiliaire.

En outre, afin de disposer d'une référence de phase permanente pour toutes les voies, une partie du signal émission est aiguillée vers le récepteur 85 par une seconde voie de réception 86 ou voie de référence, qui est une des voies de réception du radar (voie écartométrie ou voie auxiliaire).

Afin de pouvoir adopter une telle configuration de mesure, l'enceinte de mesure selon l'invention est associée à des moyens de commutation 88 appropriés tels que ceux illustrés sur la figure 8. Ces moyens sont par exemple constitués d'un coupleur de puissance 881 (coupleur 3dB), d'un commutateur 882, et d'un élément isolateur et aiguilleur 883, de type circulateur par exemple, ces éléments étant eux-mêmes préalablement étalonnés de façon à connaitre le déphasage et l'atténuation qu'ils introduisent dans la chaîne de mesure.

Par suite, après démodulation en bande de base, les moyens de traitement 87 du radar réalisent une décomposition spectrale des signaux transmis par les voies de réception 84 et 86, par Transformée de Fourier Rapide [FFT] des 2 signaux par exemple, et mesurent leur différence vectorielle.

Il est à noter que dans ce mode de réalisation, l'onde en bande de base est décalée en fréquence au niveau de l'onde émise d'une valeur de l'ordre de quelques Kilohertz par rapport à la réception qui est la fréquence traitée en bande de base

La figure 9 présente la configuration matérielle correspondant à l'utilisation des moyens techniques du radar dans le cadre du premier procédé, pour le test en réception d'un ou plusieurs éléments actifs 81 de l'antenne, ce test pouvant évidemment couvrir le test d'un élément unique 81 aussi bien que celui de l'antenne complète 19.

Conformément à ce premier procédé, le signal issu du synthétiseur intégré aux moyens 83 de génération et de réception FI du radar est transposé en hyperfréquence et émis par la sonde de test 82 de l'enceinte de mesure 11.

Le signal rayonné par la sonde de test 82 est reçu par chaque élément rayonnant 81 ou groupe d'éléments rayonnants et transmis au récepteur 85 d'une part par la voie de réception principale 91 (voie de mesure) et d'autre part par une voie de réception auxiliaire 92 (voie de référence) associée à une antenne auxiliaire 93 qui peut être constituée par un élément actif particulier de l'antenne. La voie de réception auxiliaire 92 constitue ici la référence de phase nécessaire aux mesures.

Par suite, après démodulation en bande de base, les moyens de traitement 87 du radar réalisent une décomposition spectrale des signaux transmis par les voies de réception 91 et 92, par Transformée de Fourier Rapide [FFT] des 2 signaux par exemple, et mesure leur différence vectorielle. La mesure vectorielle d'amplitude et de phase entre les différents éléments rayonnants ou groupes d'éléments rayonnants est ainsi réalisée comme pour les tests en émission, par comparaison des signaux reçus avec la voie de référence 92.

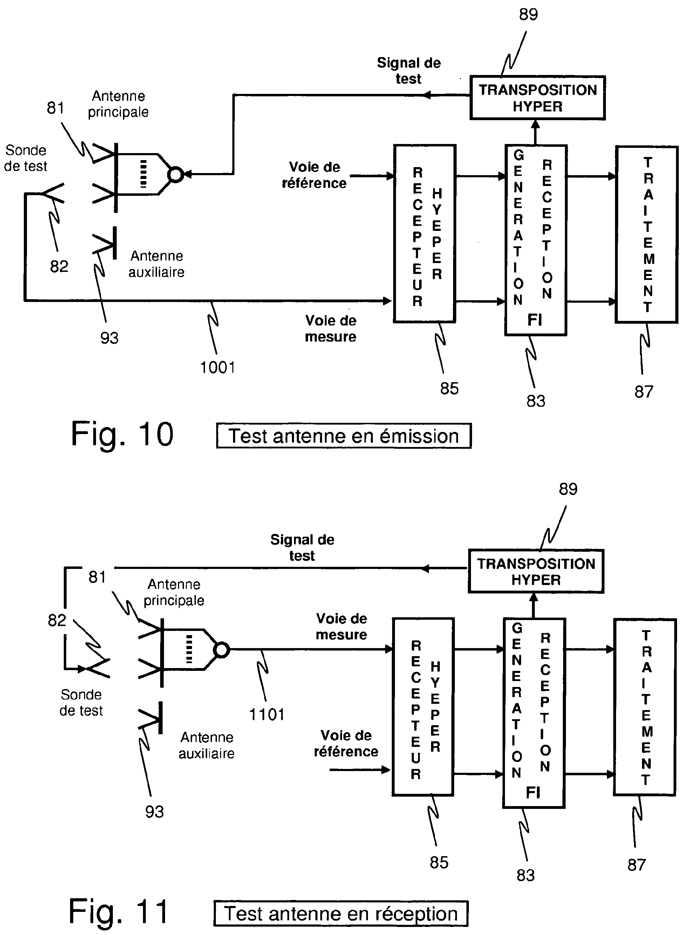

Le second procédé présenté est illustré par les figures 10 et 11. Le caractère avantageux de ce second procédé consiste en ce que, contrairement au procédé décrit précédemment, il ne nécessite pas l'utilisation d'une voie de référence pour réaliser des mesures en émission ou en réception.

L'innovation consiste ici à rendre le signal mesuré synchrone de la référence temporelle qui cadence l'analyse spectrale, réalisée par FFT. Le signal mesuré est ici le signal hyperfréquence transmis au récepteur du radar et transposé en bande de base puis numérisé, ce signal étant soit le signal capté par la sonde de mesure 82 (test de l'antenne en émission), soit le signal reçu par un ou plusieurs éléments actifs 81 de l'antenne (test de l'antenne en réception). Pour ce faire, la période de la référence temporelle étant égale à T, le synthétiseur des moyens 83 de génération et de réception FI du radar est configuré de façon à synthétiser une onde de test de période égale à N x 1/T. Ainsi, dans le temps, l'onde en bande de base générée par le synthétiseur peut être considérée comme une référence de phase pour les signaux obtenus après décomposition spectrale.

La figure 10 présente la configuration matérielle correspondant à l'utilisation des moyens techniques du radar dans le cadre du second procédé, pour le test en émission d'un ou plusieurs éléments actifs de l'antenne, ce test pouvant évidemment couvrir le test d'un élément unique 81 aussi bien que celui de l'antenne complète 19.

Le signal issu du synthétiseur intégré aux moyens 83 de génération et de réception FI du radar est émis par les différents éléments rayonnants 81. Ce signal est prélevé par la sonde de test 82 de l'enceinte de mesure 11 et transmise via une voie de réception 104, ou voie de mesure, vers le récepteur 85 du radar.

Par suite, après démodulation en bande de base, les moyens de traitement 87 du radar réalisent une décomposition spectrale du signal transmis par la voie de réception 104, par Transformée de Fourier Rapide [FFT] par exemple, et mesure directement la valeur vectorielle absolue.

Avantageusement, comme l'illustre la figure 10, pour pouvoir adopter une telle configuration de mesure, il n'est pas nécessaire d'associer des moyens de commutation particuliers complémentaires à l'enceinte de mesure 11 selon l'invention.

La figure 11 présente la configuration matérielle correspondant à l'utilisation des moyens techniques du radar dans le cadre du second procédé, pour le test en réception d'un ou plusieurs éléments actifs 81 de l'antenne, ce test pouvant évidemment couvrir le test d'un élément unique 81 aussi bien que celui de l'antenne complète 19.

Conformément à ce second procédé, le signal issu du synthétiseur des moyens 83 de génération et de réception FI du radar est transposé en hyperfréquence et émis par la sonde de test 82 de l'enceinte de mesure 11.

Le signal rayonné par la sonde de test 82 est reçu par chaque élément rayonnant 81 ou groupe d'éléments rayonnants et transmis au récepteur 85 d'une part par la seule voie de réception principale 111, ou voie de mesure. L'antenne auxiliaire 93 n'est pas utilisée ici, dans la mesure où aucune référence de phase externe n'est nécessaire.

Par suite, après démodulation en bande de base, les moyens de traitement 87 du radar réalisent une décomposition spectrale du signal transmis par la voie de réception 111 (voie de mesure), par Transformée de Fourier Rapide [FFT] par exemple. La mesure vectorielle d'amplitude et de phase est ainsi réalisée de manière directe comme pour les tests en émission.

Il est à noter que ces deux procédés de mesure peuvent bien entendu être mis en oeuvre aussi bien en utilisant une enceinte de mesure comportant une seule sonde, telle que celle illustrée par les figures 3 et 5, qu'une enceinte de mesure comportant plusieurs sondes, telle que celle illustrée par la figure 4.

**Revendications**

1. Dispositif de test et de calibration destiné à réaliser des opérations de test et de calibration d'une antenne active (19) dans une zone où le diagramme d'antenne n'est pas encore formé comprenant un radar équipé d'une antenne active (19), le dispositif de test comprenant ladite antenne active (19), ladite antenne étant constituée d'une pluralité d'éléments actifs d'émission-réception agencés de façon à former une surface rayonnante (14), ledit dispositif comportant :

   - une enceinte de mesure (11) configurée pour être montée en regard de la face rayonnante (14) de l'antenne sur la structure (111) supportant l'antenne et dans laquelle est positionnée au moins une sonde de test (16) apte à capter et à rayonner des signaux électromagnétiques hyperfréquence,
   - des moyens (71) pour générer un signal radioélectrique hyperfréquence de test ainsi que des moyens (72) pour effectuer la réception d'un signal radioélectrique hyperfréquence et effectuer une mesure vectorielle du signal reçu ;

l'enceinte de mesure (11) comportant :

   - une paroi (12) formant une cavité (13) pourvue d'une ouverture, l'ouverture étant configurée de façon à ce que la cavité soit obturée par la face rayonnante (14) de l'antenne lorsque l'enceinte (11) est montée sur la structure (111) supportant l'antenne;
   - des moyens permettant de positionner la sonde de test à l'intérieur de la cavité dans une position donnée ;
   - des moyens de fixation (23) permettant de réaliser le montage de l'enceinte de mesure (11) sur la structure (111) supportant l'antenne, ces moyens étant configurés de façon à assurer, après montage, un positionnement axial connu de l'enceinte de mesure (11) par rapport à la face rayonnante (14) de l'antenne;La paroi (12) formant la cavité (13) étant revêtue sur sa face interne d'éléments (15) absorbant les ondes radioélectriques, sa face externe étant configurée pour former un blindage électrique ;

le dispositif comprenant une pluralité de sondes et étant en outre **caractérisé en ce que**, compte tenu de la profondeur D2 de la cavité (13) définie par l'enceinte de mesure (11) et des dimensions du diagramme de la sonde de test utilisée, l'enceinte de mesure comporte une pluralité de sondes de test (41, 42), chaque sonde étant montée sur un moyen (43) permettant de la positionner à l'intérieur de la cavité (13) dans une position connue, le nombre de sondes de test et la position de chacune de ces sondes étant définis de façon à ce que la réunion de leurs diagrammes de rayonnement couvre la totalité de la surface active (14) de l'antenne (19) et que chacune des sondes (41, 42) soit éclairée par le lobe principal du diagramme de rayonnement d'un ou plusieurs éléments actifs, ou sous-réseaux actifs, constituant l'antenne (19),
les dimensions de l'enceinte de mesure (11) étant déterminées de façon à ce que, compte tenu de la au moins une position de chaque sonde (16) dans la cavité (11), la distance de la sonde à chacun des éléments actifs ou sous-réseau d'éléments actifs constituant l'antenne soit supérieure à $d^2/2\cdot\lambda$, d représentant la taille de l'ouverture rayonnante équivalente d'un élément actif de l'antenne (19) ou d'un sous-réseau constitué d'éléments actifs et $\lambda$ la longueur d'onde moyenne de fonctionnement de l'antenne.

2. Dispositif de test et de calibration destiné à réaliser des opérations de test et de calibration d'une antenne active (19) dans une zone où le diagramme d'antenne n'est pas encore formé comprenant un radar équipé d'une antenne active (19), le dispositif de test et de calibration comprenant ladite antenne active (19), ladite antenne étant constituée d'une pluralité d'éléments actifs d'émission-réception agencés de façon à former une surface rayonnante (14), ledit dispositif comportant :

- une enceinte de mesure (11) configurée pour être montée en regard de la face rayonnante (14) de l'antenne sur la structure (111) supportant l'antenne et dans laquelle est positionnée au moins une sonde de test (16) apte à capter et à rayonner des signaux électromagnétiques hyperfréquence,
- des moyens (71) pour générer un signal radioélectrique hyperfréquence de test ainsi que des moyens (72) pour effectuer la réception d'un signal radioélectrique hyperfréquence et effectuer une mesure vectorielle du signal reçu ;

l'enceinte de mesure (11) comportant :

- une paroi (12) formant une cavité (13) pourvue d'une ouverture, l'ouverture étant configurée de façon à ce que la cavité soit obturée par la face rayonnante (14) de l'antenne lorsque l'enceinte (11) est montée sur la structure (111) supportant l'antenne ;
- des moyens permettant de positionner la sonde de test à l'intérieur de la cavité dans une position donnée ;
- des moyens de fixation (23) permettant de réaliser le montage de l'enceinte de mesure (11) sur la structure (111) supportant l'antenne, ces moyens étant configurés de façon à assurer, après montage, un positionnement axial connu de l'enceinte de mesure (11) par rapport à la face rayonnante (14) de l'antenne;La paroi (12) formant la cavité (13) étant revêtue sur sa face interne d'éléments (15) absorbant les ondes radioélectriques, sa face externe étant configurée pour former un blindage électrique ;

le dispositif comprenant une unique sonde, et étant **caractérisé en ce que**, compte tenu de la profondeur D2 de la cavité (13) définie par l'enceinte de mesure (11) et des dimensions du diagramme de la sonde de test utilisée (51), ladite sonde de test est montée sur des moyens de positionnement (61-64) configurés de façon à permettre le positionnement de la sonde de test (51) à une pluralité de positions à l'intérieur de la cavité (13), ces positions étant déterminées de façon à ce que, pour chaque position, la sonde de test (51) soit éclairée par le lobe principal du diagramme de rayonnement d'un ou plusieurs éléments actifs, ou sous-réseaux actifs, constituant l'antenne (19) et que l'ensemble des positions permette à la sonde (51) de couvrir l'ensemble de éléments actifs, ou des sous-réseaux actifs, constituant l'antenne (19) ;

les dimensions de l'enceinte de mesure (11) étant déterminées de façon à ce que, compte tenu de la au moins une position de chaque sonde (16) dans la cavité (11), la distance de la sonde à chacun des éléments actifs ou sous-réseau d'éléments actifs constituant l'antenne soit supérieure à $d^2/2 \cdot \lambda$, d représentant la taille de l'ouverture rayonnante équivalente d'un élément actif de l'antenne (19) ou d'un sous-réseau constitué d'éléments actif et $\lambda$ la longueur d'onde moyenne de fonctionnement de l'antenne.

3. Dispositif de test et de calibration l'une quelconque des revendications 1 à 2, **caractérisé en ce que** l'antenne active à tester étant une antenne radar montée à l'avant d'un aéronef et placée sous la coiffe (22) formant la pointe avant dudit aéronef, les moyens de fixation (23) de l'enceinte de mesure sont identiques aux moyens permettant de fixer la coiffe sur la structure avant de l'aéronef qui supporte l'antenne.

4. Dispositif de test et de calibration selon l'une des revendications 1 à 3, **caractérisé en ce que** la profondeur de la cavité (13) définie par l'enceinte de mesure (11) est déterminée de façon à permettre une mesure en champ intermédiaire ou lointain du signal reçu par la sonde de test (16) lorsqu'un ou plusieurs éléments actifs de l'antenne (19) sont en émission, compte tenu de la position de la sonde de test (16) dans la cavité (13).

5. Dispositif de test et de calibration selon l'une quelconque des revendications 1 à 4, **caractérisé en ce que** les moyens (61-64) permettant de positionner la sonde de test (51) à l'intérieur de la cavité (13) sont configurés de façon à ce que lorsque l'enceinte de mesure (11) est fixée sur la structure (111) supportant l'antenne la distance séparant une sonde de test (51) de chacun des éléments de l'antenne (19) qu'elle couvre diffère, d'une valeur théorique donnée, d'un écart inférieur à l'écart $\Delta L$ défini par :

$$\Delta L = (\Delta \varphi \cdot \lambda)/360$$

$\Delta \varphi$ représentant l'erreur de phase systématique exprimée en degrés.

6. Dispositif de test et de calibration selon l'une quelconque des revendications 1 à 5, dans lequel les moyens pour générer un signal radioélectrique hyperfréquence de test et les moyens pour effectuer la réception d'un signal radioélectrique hyper fréquence et effectuer une mesure vectorielle du signal reçu sont constitués par l'équipement radar associé à l'antenne testée.

7. Dispositif de test et de calibration selon l'une quelconque des revendications précédentes, dans lequel l'enceinte (11) est constituée d'une paroi périphérique (12), définissant une cavité (13), l'enceinte (11) comportant une ouverture présentant des dimensions suffisantes pour que la face active (14) de l'antenne puisse être placée à l'entrée de la cavité sans qu'aucun obstacle matériel ne soit placé entre face active de l'antenne et l'intérieur de la cavité (13) et dans lequel l'enceinte est agencée de manière à pouvoir englober la totalité de l'antenne (19) de façon que l'antenne (19) ferme l'ouverture.

8. Procédé pour réaliser le test d'une antenne active (81) en émission ou en réception, d'un dispositif de test et de calibration selon l'une quelconque des revendications précédentes, au moyen du dispositif de test et de calibration, dans lequel les moyens (83-89) pour générer un signal radioélectrique hyperfréquence de test et les moyens (83-85) pour effectuer la réception d'un signal radioélectrique hyper fréquence et effectuer une mesure vectorielle du signal reçu étant constitués par l'équipement radar (111) associé à l'antenne (19) testée dans lequel :

- on produit un signal de test hyperfréquence qui est rayonné à l'intérieur de l'enceinte de mesure (11) au moyen de la chaine d'émission du radar,
- on effectue au moyen de la chaine de réception du radar, la réception et la démodulation du signal (84) capté par des moyens de réception,
- on numérise le signal capté par l'antenne sous-test au moyen des moyens de traitement du signal du radar.

9. Procédé pour réaliser le test d'une antenne active (81) en émission selon la revendication précédente, dans lequel :

on produit un signal de test hyperfréquence et un signal de référence au moyen de la chaine d'émission du radar, le signal de test étant rayonné à l'intérieur de l'enceinte de mesure (11), via l'antenne sous test (81) ;

- on effectue séparément, au moyen de la chaine de réception du radar, la réception et la démodulation du signal (84) capté par la sonde de test (82) d'une part et du signal de référence (86) d'autre part ;
- on mesure l'amplitude et la phase relatives du signal (84) capté par l'antenne sous test (19) par rapport à l'amplitude et à la phase du signal de référence (86), cette amplitude et cette phase relative étant déterminées, après numérisation des deux signaux, par les moyens de traitement du signal (87) du radar et comparées à des valeurs théoriques de référence.

10. Procédé pour réaliser le test d'une antenne active (81) en réception selon la revendication 8 dans lequel :

- on produit un signal de test hyperfréquence au moyen de la chaine d'émission du radar, le signal de test étant rayonné à l'intérieur de l'enceinte de mesure (11), via la sonde de test (82) ;
- on effectue séparément, au moyen de la chaine de réception du radar la réception et la démodulation du signal (91) capté par l'antenne sous test (81) d'une part et du signal (92) capté par une antenne auxiliaire (93) solidaire de l'antenne sous test (81), ce dernier signal (92) étant considéré comme signal de référence ;
- on mesure l'amplitude et la phase relatives du signal (91) capté par l'antenne sous test par rapport à l'amplitude et à la phase du signal de référence (92), cette amplitude et cette phase relative étant déterminées, après numérisation des deux signaux, par les moyens de traitement du signal (87) du radar et comparées à des valeurs théoriques de référence.

11. Procédé pour réaliser le test d'une antenne active (81) en émission selon la revendication 8, dans lequel :

- on produit un signal de test hyperfréquence et un signal de référence au moyen de la chaine d'émission du radar, le signal de test étant rayonné à l'intérieur de l'enceinte de mesure (11), via l'antenne sous test (81), le signal de test étant obtenu par transposition d'un signal de test en fréquence intermédiaire dont la fréquence est déduite, par multiplication de fréquence, d'une horloge de référence qui sert également de référence pour les moyens de traitement du signal (87) du radar (111);
- on effectue au moyen de la chaine de réception du radar la réception et la démodulation du signal (101) capté par la sonde de test (82) ;
- on mesure l'écart d'amplitude et de phase du signal (101) capté par l'antenne sous test (81) par rapport à l'horloge de référence, l'amplitude et la phase du signal capté (101) étant déterminées, après numérisation, par le moyens de traitement du signal (87) du radar (111) et comparées à des valeurs théoriques de référence.

12. Procédé pour réaliser le test d'une antenne active (81) en réception selon la revendication 9, dans lequel :

- on produit un signal de test hyperfréquence et un signal de référence au moyen de la chaine d'émission du radar, le signal de test étant rayonné à l'intérieur de l'enceinte de mesure (11), via la sonde de test (82), le signal de test étant obtenu par transposition d'un signal de test en fréquence intermédiaire dont la fréquence est déduite, par multiplication de fréquence, d'une horloge de référence qui sert également de référence pour les moyens de traitement du signal (87) du radar (111) ;

- on effectue au moyen de la chaine de réception du radar la réception et la démodulation du signal (1101) capté par l'antenne sous test (81) ;

- on mesure l'écart d'amplitude et de phase du signal (1101) capté par l'antenne sous test (81) par rapport à l'horloge de référence, l'amplitude et la phase du signal mesuré étant déterminées, après numérisation, par le moyens de traitement du signal (87) du radar et comparées à des valeurs théoriques de référence.

## Patentansprüche

1. Prüf- und Kalibriervorrichtung zum Durchführen von Prüf- und Kalibriemorgängen einer aktiven Antenne (19) in einer Zone, in der das Antennendiagramm noch nicht gebildet ist, umfassend ein mit einer aktiven Antenne (19) ausgestattetes Radar, wobei die Prüfvorrichtung die aktive Antenne (19) umfasst, wobei die Antenne von mehreren aktiven Sende-/Empfangselementen zum Bilden einer Strahlungsfläche (14) gebildet wird, wobei die Vorrichtung Folgendes umfasst:

   - eine Messkammer (11), die zum Montieren gegenüber der Strahlungsfläche (14) der Antenne an der die Antenne tragenden Struktur (111) konfiguriert ist und in der wenigstens eine Prüfsonde (16) zum Erfassen und Ausstrahlen von elektromagnetischen Mikrowellensignalen positioniert ist,

   - Mittel (71) zum Erzeugen eines radioelektrischen Mikrowellenprüfsignals sowie Mittel (72) zum Durchführen des Empfangs eines radioelektrischen Mikrowellensignals und zum Durchführen einer Vektormessung des empfangenen Signals;

   wobei die Messkammer (11) Folgendes umfasst:

   - eine Wand (12), die einen Hohlraum (13) bildet, der mit einer Öffnung versehen ist, wobei die Öffnung so konfiguriert ist, dass der Hohlraum von der Strahlungsfläche (14) der Antenne verschlossen wird, wenn die Kammer (11) an der die Antenne tragenden Struktur (111) montiert ist;

   - Mittel zum Positionieren der Prüfsonde im Innern des Hohlraums in einer gegebenen Position;

   - Befestigungsmittel (23) zum Durchführen der Montage der Messkammer (11) an der die Antenne tragenden Struktur (111), wobei diese Mittel so konfiguriert sind, dass sie nach der Montage eine bekannte axiale Positionierung der Messkammer (11) mit Bezug auf die Strahlungsfläche (14) der Antenne gewährleisten; wobei die den Hohlraum (13) bildende Wand (12) auf ihrer Innenfläche mit Elementen (15) ausgekleidet ist, die die radioelektrischen Wellen absorbieren, wobei ihre Außenfläche zum Bilden einer elektrischen Abschirmung konfiguriert ist;

wobei die Vorrichtung mehrere Sonden umfasst und ferner **dadurch gekennzeichnet ist, dass** unter Berücksichtigung der Tiefe D2 des durch die Messkammer (11) definierten Hohlraums (13) und die Abmessungen des Diagramms der benutzten Prüfsonde, die Messkammer mehrere Prüfsonden (41, 42) umfasst, wobei jede Sonde an einem Mittel (43) montiert ist, das ihre Positionierung im Innern des Hohlraums (13) in einer bekannten Position zulässt, wobei die Anzahl der Prüfsonden und die Position von jeder dieser Sonden so definiert werden, dass die Vereinigung ihrer Strahlungsdiagramme die Gesamtheit der aktiven Fläche (14) der Antenne (19) bedeckt, und dass jede der Sonden (41, 42) von der Hauptkeule des Strahlungsdiagramms von einem oder mehreren die Antenne (19) bildenden aktiven Elementen oder aktiven Subnetzen beleuchtet wird, wobei die Abmessungen der Messkammer (11) so bestimmt werden, dass unter Berücksichtigung der wenigstens einen Position jeder Sonde (16) in dem Hohlraum (11), die Distanz der Sonde von jedem der die Antenne bildenden aktiven Elemente oder aktiven Elementsubnetze größer als $d^2/2\lambda$ ist, wobei d die Größe der äquivalenten Strahlungsöffnung eines aktiven Elements der Antenne (19) oder eines von aktiven Elementen gebildeten Subnetzes repräsentiert, und $\lambda$ die mittlere Betriebswellenlänge der Antenne ist.

2. Prüf- und Kalibriervorrichtung zum Durchführen von Prüf- und Kalibriemorgängen einer aktiven Antenne (19) in einer Zone, in der das Antennendiagramm noch nicht gebildet ist, umfassend ein mit einer aktiven Antenne (19) ausgestattetes Radar, wobei die Prüfvorrichtung die aktive Antenne (19) umfasst, wobei die Antenne von mehreren aktiven Sende-/Empfangselementen zum Bilden einer Strahlungsfläche (14) gebildet wird, wobei die Vorrichtung Folgendes umfasst:

   - eine Messkammer (11), die zum Montieren gegenüber der Strahlungsfläche (14) der Antenne an der die Antenne tragenden Struktur (111) konfiguriert ist und in der wenigstens eine Prüfsonde (16) zum Erfassen und Ausstrahlen von elektromagnetischen Mikrowellensignalen positioniert ist,

- Mittel (71) zum Erzeugen eines radioelektrischen Mikrowellenprüfsignals sowie Mittel (72) zum Durchführen des Empfangs eines radioelektrischen Mikrowellensignals und zum Durchführen einer Vektormessung des empfangenen Signals;

wobei die Messkammer (11) Folgendes umfasst:

- eine Wand (12), die einen Hohlraum (13) bildet, der mit einer Öffnung versehen ist, wobei die Öffnung so konfiguriert ist, dass der Hohlraum von der Strahlungsfläche (14) der Antenne verschlossen wird, wenn die Kammer (11) an der die Antenne tragenden Struktur (111) montiert ist;
- Mittel zum Positionieren der Prüfsonde im Innern des Hohlraums in einer gegebenen Position;
- Befestigungsmittel (23) zum Durchführen der Montage der Messkammer (11) an der die Antenne tragenden Struktur (111), wobei diese Mittel so konfiguriert sind, dass sie nach der Montage eine bekannte axiale Positionierung der Messkammer (11) in Bezug auf die Strahlungsfläche (14) der Antenne gewährleisten; wobei die den Hohlraum (13) bildende Wand (12) auf ihrer Innenfläche mit Elementen (15) ausgekleidet ist, die die radioelektrischen Wellen absorbieren, wobei ihre Außenfläche zum Bilden einer elektrischen Abschirmung konfiguriert ist;

wobei die Vorrichtung eine einzige Sonde umfasst und **dadurch gekennzeichnet ist, dass** unter Berücksichtigung der Tiefe D2 des durch die Messkammer (11) definierten Hohlraums (13) und die Abmessungen des Diagramms der benutzten Prüfsonde (51), die Prüfsonde an Positionierungsmitteln (61-64) montiert ist, die so konfiguriert sind, dass sie die Positionierung der Prüfsonde (51) an mehreren Positionen im Innern des Hohlraums (13) zulassen, wobei diese Positionen so bestimmt werden, dass für jede Position die Prüfsonde (51) von der Hauptkeule des Strahlungsdiagramms von einem oder mehreren die Antenne (19) bildenden aktiven Elementen oder aktiven Subnetzen beleuchtet wird, und die Gesamtheit der Position es zulässt, dass die Sonde (51) alle die Antenne (19) bildenden aktiven Elemente oder aktiven Subnetze bedeckt; wobei die Abmessungen der Messkammer (11) so bestimmt werden, dass unter Berücksichtigung der oder wenigstens einer Position jeder Sonde (16) in dem Hohlraum (11), die Distanz der Sonde von jedem der die Antenne bildenden aktiven Elemente oder aktiven Elementsubnetze größer als $d^2/2\lambda$ ist, wobei d die Größe der äquivalenten Strahlungsöffnung eines aktiven Elements der Antenne (19) oder eines von aktiven Elementen gebildeten Subnetzes repräsentiert und $\lambda$ die mittlere Betriebswellenlänge der Antenne ist.

3. Prüf- und Kalibriervorrichtung nach einem der Ansprüche 1 bis 2, **dadurch gekennzeichnet, dass** die zu prüfende aktive Antenne eine Radarantenne ist, die vor einem Luftfahrzeug montiert und unter dem Bugkonus (22) platziert ist, der die Spitze vor dem Luftfahrzeug bildet, wobei die Befestigungsmittel (23) der Messkammer mit den Mitteln zum Fixieren des Bugkonus an der Struktur vor dem die Antenne tragenden Luftfahrzeug identisch sind.

4. Prüf- und Kalibriervorrichtung nach einem der Ansprüche 1 bis 3, **dadurch gekennzeichnet, dass** die durch die Messkammer (11) definierte Tiefe des Hohlraums (13) so bestimmt wird, dass ein intermediäres oder fernes Messfeld des empfangenen Signals durch die Prüfsonde (16), während ein oder mehrere aktive Elemente der Antenne (19) senden, unter Berücksichtigung der Position der Prüfsonde (16) in dem Hohlraum (13) zugelassen wird.

5. Prüf- und Kalibriervorrichtung nach einem der Ansprüche 1 bis 4, **dadurch gekennzeichnet, dass** die Mittel (61-64), die das Positionieren der Prüfsonde (51) im Innern des Hohlraums (13) zulassen, so konfiguriert sind, dass sich, wenn die Messkammer (11) an der die Antenne tragenden Struktur (111) befestigt ist, die Distanz zwischen einer Prüfsonde (51) und jedem der Elemente der Antenne (19), die sie bedeckt, von einem gegebenen theoretischen Wert mit einer Abweichung von weniger als ΔL unterscheidet, definiert durch:

$$\Delta L = (\Delta\varphi \cdot \lambda)/360$$

wobei $\Delta\varphi$ den in Grad ausgedrückten systematischen Phasenfehler repräsentiert.

6. Prüf- und Kalibriervorrichtung nach einem der Ansprüche 1 bis 5, wobei die Mittel zum Erzeugen eines radioelektrischen Mikrowellenprüfsignals und die Mittel zum Bewirken des Empfangs eines radioelektrischen Mikrowellensignals und zum Durchführen einer Vektormessung des empfangenen Signals von mit der zu prüfenden Antenne assoziierter Radarausrüstung gebildet werden.

7. Prüf- und Kalibriervorrichtung nach einem der vorherigen Ansprüche, wobei die Kammer (11) von einer einen Hohlraum (13) definierenden Umfangswand (12) gebildet wird, wobei die Kammer (11) eine Öffnung mit Abmessungen aufweist, die ausreichen, damit die aktive Fläche (14) der Antenne am Eingang des Hohlraums platziert werden kann, ohne dass ein materielles Hindernis zwischen der aktiven Fläche der Antenne und dem Innern des Hohlraums (13) platziert wird, und wobei die Kammer so ausgelegt ist, dass sie die Gesamtheit der Antenne (19) so umfasst, dass die Antenne (19) die Öffnung verschließt.

8. Verfahren zum Durchführen des Prüfens einer aktiven Sende- oder Empfangsantenne (81) einer Prüf- und Kalibriervorrichtung nach einem der vorherigen Ansprüche mittels der Prüf- und Kalibriervorrichtung, wobei die Mittel (83-89) zum Erzeugen eines radioelektrischen Mikrowellenprüfsignals und die Mittel (83-85) zum Bewirken des Empfangs eines radioelektrischen Mikrowellensignals und zum Durchführen einer Vektormessung des empfangenen Signals von mit der geprüften Antenne (19) assoziierte Radarausrüstung (111) gebildet wird, wobei:

- ein Mikrowellenprüfsignal erzeugt wird, das ins Innere der Messkammer (11) mittels der Sendekette des Radars gestrahlt wird,
- mittels der Empfangskette des Radars der Empfang und die Demodulation des von den Empfangsmitteln erfassten Signals (84) durchgeführt wird,
- das von der geprüften Antenne erfasste Signal mittels Signalverarbeitungsmitteln des Radars digitalisiert wird.

9. Verfahren zum Durchführen des Prüfens einer aktiven Sendeantenne (81) nach dem vorherigen Anspruch, wobei:

ein Mikrowellenprüfsignal und ein Referenzsignal mittels der Sendekette des Radars produziert werden, wobei das Prüfsignal ins Innere der Messkammer (11) über die zu prüfende Antenne (81) gestrahlt wird;

- mittels der Empfangskette des Radars der Empfang und die Demodulation des von der Prüfsonde (82) erfassten Signals (84) einerseits und des Referenzsignals (86) andererseits separat durchgeführt werden;
- die relative Amplitude und Phase des von der zu prüfenden Antenne (19) erfassten Signals (84) mit Bezug auf die Amplitude und Phase des Referenzsignals (86) gemessen werden, wobei diese relative Amplitude und Phase nach der Digitalisierung der beiden Signale mittels der Signalverarbeitungsmittel (87) des Radars ermittelt und mit theoretischen Referenzwerten verglichen werden.

10. Verfahren zum Durchführen des Prüfens einer aktiven Empfangsantenne (81) nach Anspruch 8, wobei:

- ein Mikrowellenprüfsignal mittels der Sendekette des Radars erzeugt wird, wobei das Prüfsignal über die Prüfsonde (82) ins Innere der Messkammer (11) gestrahlt wird;
- mittels der Empfangskette des Radars der Empfang und die Demodulation des von der zu prüfenden Antenne (81) erfassten Signals (91) einerseits und des von einer mit der zu prüfenden Antenne (81) fest verbundenen Zusatzantenne (93) erfassten Signals (92) andererseits separat durchgeführt werden, wobei letzteres Signal (92) als Referenzsignal angesehen wird;
- die relative Amplitude und Phase des von der zu prüfenden Antenne erfassten Signals (91) mit Bezug auf die Amplitude und Phase des Referenzsignals (92) gemessen werden, wobei diese relative Amplitude und Phase nach der Digitalisierung der beiden Signale durch die Signalverarbeitungsmittel (87) des Radars ermittelt und mit theoretischen Referenzwerten verglichen werden.

11. Verfahren zum Durchführen des Prüfens einer aktiven Sendeantenne (81) nach Anspruch 8, wobei:

- ein Mikrowellenprüfsignal und ein Referenzsignal mittels der Sendekette des Radars erzeugt werden, wobei das Prüfsignal über die geprüfte Antenne (81) ins Innere der Messkammer (11) gestrahlt wird, wobei das Prüfsignal durch Transposition eines Zwischenfrequenzprüfsignals erhalten wird, dessen Frequenz durch Frequenzmultiplikation von einem Referenztakt abgeleitet wird, der auch als Referenz für die Signalverarbeitungsmittel (87) des Radars (111) dient;
- mittels der Empfangskette des Radars der Empfang und die Demodulation des von der Prüfsonde (82) erfassten Signals (101) durchgeführt werden;
- der Abstand von Amplitude und Phase des von der zu prüfenden Antenne (81) erfassten Signals (101) mit Bezug auf den Referenztakt gemessen wird, wobei die Amplitude und die Phase des erfassten Signals (101) nach der Digitalisierung durch die Signalverarbeitungsmittel (87) des Radars (111) ermittelt und mit theoretischen Referenzwerten verglichen werden.

12. Verfahren zum Durchführen der Prüfung einer aktiven Empfangsantenne (81) nach Anspruch 9, wobei:

- ein Mikrowellenprüfsignal und ein Referenzsignal mittels der Sendekette des Radars produziert werden, wobei das Prüfsignal über die Prüfsonde (82) ins Innere der Messkammer (11) gestrahlt wird, wobei das Prüfsignal durch Transposition eines Zwischenfrequenzprüfsignals erhalten wird, dessen Frequenz durch Frequenzmultiplikation von einem Referenztakt abgeleitet wird, der auch als Referenz für die Signalverarbeitungsmittel (87) des Radars (111) dient;
- mittels der Empfangskette des Radars der Empfang und die Demodulation des von der zu prüfenden Antenne (81) erfassten Signals (1101) durchgeführt werden;
- die Amplituden- und Phasenabweichung des von der zu prüfenden Antenne (81) erfassten Signals (1101) mit Bezug auf den Referenztakt gemessen wird, wobei die Amplitude und die Phase des gemessenen Signals nach der Digitalisierung durch das Signalverarbeitungsmittel (87) des Radars ermittelt und mit theoretischen Referenzwerten verglichen werden.

**Claims**

1. Test and calibration device which is intended to carry out test and calibration operations of an active antenna (19) in a zone in which the antenna pattern is not yet formed comprising a radar which is provided with an active antenna (19), the test device comprising the active antenna (19), the antenna being constituted by a plurality of active emission/reception elements which are arranged in order to form a radiating surface (14), the device comprising:

   - a measuring chamber (11) which is configured to be mounted facing the radiating face (14) of the antenna on the structure (111) supporting the antenna and in which there is positioned at least one test probe (16) which is capable of capturing and radiating hyperfrequency electromagnetic signals,
   - means (71) for generating a hyperfrequency radioelectric test signal and means (72) for carrying out the reception of a hyperfrequency radioelectric signal and carrying out a vector measurement of the signal received;

   the measuring chamber (11) comprising:

   - a wall (12) which forms a cavity (13) which is provided with an opening, the opening being configured so that the cavity is blocked by the radiating face (14) of the antenna when the chamber (11) is mounted on the structure (111) supporting the antenna;
   - means enabling the test probe to be positioned inside the cavity at a specific position;
   - fixing means (23) which enable the measuring chamber (11) to be mounted on the structure (111) which supports the antenna, these means being configured in order to ensure, after assembly, a known axial positioning of the measuring chamber (11) relative to the radiating face (14) of the antenna; the wall (12) forming the cavity (13) being covered on the inner face thereof with elements (15) which absorb the radioelectric waves, the outer face thereof being configured in order to form an electric shielding;

the device comprising a plurality of probes and further being **characterised in that**, taking into account the depth D2 of the cavity (13) defined by the measuring chamber (11) and the dimensions of the pattern of the test probe used, the measuring chamber comprises a plurality of test probes (41, 42), each probe being mounted on a means (43) which enables it to be positioned inside the cavity (13) in a known position, the number of test probes and the position of each of these probes being defined so that the combination of their radiation patterns covers all of the active surface (14) of the antenna (19) and each of the probes (41, 42) is illuminated by the main lobe of the radiation pattern of one or more active elements, or active sub-networks, constituting the antenna (19),

the dimensions of the measuring chamber (11) being determined so that, taking into account the at least one position of each probe (16) in the cavity (11), the distance of the probe from each of the active elements or sub-network of active elements which constitute the antenna is greater than $d^2/2\lambda$, d representing the size of the equivalent radiating opening of an active element of the antenna (19) or a sub-network which is constituted by active elements and $\lambda$ the mean operation wavelength of the antenna.

2. Test and calibration device which is intended to carry out test and calibration operations of an active antenna (19) in a zone in which the antenna pattern is not yet formed comprising a radar which is provided with an active antenna (19), the test and calibration device comprising the active antenna (19), the antenna being constituted by a plurality of active emission/reception elements which are arranged in order to form a radiating surface (14), the device comprising:

   - a measuring chamber (11) which is configured to be mounted facing the radiating face (14) of the antenna on the structure (111) supporting the antenna and in which there is positioned at least one test probe (16) which is capable of capturing and radiating hyperfrequency electromagnetic signals,

- means (71) for generating a hyperfreqeuncy radioelectric test signal and means (72) for carrying out the reception of a hyperfrequency radioelectric signal and carrying out a vector measurement of the signal received;

the measuring chamber (11) comprising:

- a wall (12) which forms a cavity (13) which is provided with an opening, the opening being configured so that the cavity is blocked by the radiating face (14) of the antenna when the chamber (11) is mounted on the structure (111) supporting the antenna;
- means enabling the test probe to be positioned inside the cavity at a specific position;
- fixing means (23) which enable the measuring chamber (11) to be mounted on the structure (111) which supports the antenna, these means being configured in order to ensure, after assembly, a known axial positioning of the measuring chamber (11) relative to the radiating face (14) of the antenna; the wall (12) forming the cavity (13) being covered on the inner face thereof with elements (15) which absorb the radioelectric waves, the outer face thereof being configured in order to form an electric shielding;

the device comprising a single probe and being **characterised in that**, taking into account the depth D2 of the cavity (13) defined by the measuring chamber (11) and the dimensions of the pattern of the test probe (51) used, the test probe is mounted on positioning means (61-64) which are configured to enable the test probe (51) to be positioned at a plurality of positions inside the cavity (13), these positions being determined so that, for each position, the test probe (51) is illuminated by the main lobe of the radiation pattern of one or more active elements, or active sub-networks, constituting the antenna (19), and all the positions allow the probe (51) to cover all the active elements, or active sub-networks, which constitute the antenna (19);
the dimensions of the measuring chamber (11) being determined so that, taking into account the at least one position of each probe (16) in the cavity (11), the distance of the probe from each of the active elements or sub-network of active elements which constitute the antenna is greater than $d^2/2\lambda$, d representing the size of the equivalent radiating opening of an active element of the antenna (19) or a subnetwork which is constituted by active elements and $\lambda$ the mean operation wavelength of the antenna.

3. Test and calibration device according to either claim 1 or claim 2, **characterised in that**, the active antenna to be tested being a radar antenna which is mounted at the front of an aircraft and placed below the fairing (22) which forms the front tip of the aircraft, the fixing means (23) of the measuring chamber are identical to the means which enable the fairing to be fixed to the front structure of the aircraft which supports the antenna.

4. Test and calibration device according to any one of claims 1 to 3, **characterised in that** the depth of the cavity (13) defined by the measuring chamber (11) is determined in order to enable a measurement in the intermediate or remote field of the signal received by the test probe (16) when one or more active elements of the antenna (19) are emitting, taking into account the position of the test probe (16) in the cavity (13).

5. Test and calibration device according to any one of claims 1 to 4, **characterised in that** the means (61-64) which enable the test probe (51) to be positioned inside the cavity (13) are configured so that, when the measuring chamber (11) is fixed to the structure (111) which supports the antenna, the distance separating a test probe (51) from each of the elements of the antenna (19) which it covers differs, by a specific theoretical value, by a deviation which is less than the deviation ∆L defined by:

$$\Delta L = (\Delta \varphi \cdot \lambda)/360$$

∆φ representing the system phase error expressed in degrees.

6. Test and calibration device according to any one of claims 1 to 5, wherein the means for generating a test hyperfrequency radioelectric signal and the means for bringing about the reception of a hyperfrequency radioelectric signal and for carrying out a vector measurement of the signal received are constituted by the radar equipment which is associated with the tested antenna.

7. Test and calibration device according to any one of the preceding claims, wherein the chamber (11) is constituted by a peripheral wall (12) which defines a cavity (13), the chamber (11) comprising an opening which has dimensions which are sufficient for the active face (14) of the antenna to be able to be placed at the inlet of the cavity without any physical obstacle being placed between the active face of the antenna and the inner side of the cavity (13) and wherein the chamber is arranged so as to be able to surround the whole of the antenna (19) so that the antenna (19) closes the opening.

8. Method for carrying out the test of an active antenna (81) during emission or reception of a test and calibration device according to any one of the preceding claims, using the test and calibration device, wherein the means (83-89) for generating a test hyperfrequency radioelectric signal and the means (83-85) for bringing about the reception of a hyperfrequency radioelectric signal and carrying out a vector measurement of the signal received being constituted by the radar equipment (111) which is associated with the tested antenna (19), wherein:

- there is produced a test hyperfrequency signal which is radiated inside the measuring chamber (11) using the emission chain of the radar,
- using the reception chain of the radar, the signal (84) captured by the reception means is received and demodulated,
- the signal captured by the antenna under test is digitised using the means for processing the signal of the radar.

9. Method for carrying out the test of an active antenna (81) during emission according to the preceding claim, wherein:

a test hyperfrequency signal and a reference signal are produced using the emission chain of the radar, the test signal being radiated inside the measuring chamber (11), via the antenna (81) under test;

- there is carried out separately, using the reception chain of the radar, the reception and demodulation of the signal (84) captured by the test probe (82), on the one hand, and the reference signal (86), on the other hand;
- the relative amplitude and phase of the signal (84) captured by the antenna (19) under test are measured relative to the amplitude and the phase of the reference signal (86), this amplitude and this relative phase being determined, after digitisation of the two signals, by the means for processing the signal (87) of the radar and compared to theoretical reference values.

10. Method for carrying out the test of an active antenna (81) during reception according to claim 8, wherein:

- a test hyperfrequency signal is produced using the emission chain of the radar, the test signal being radiated inside the measuring chamber (11), via the test probe (82);
- there is carried out separately, using the reception chain of the radar, the reception and demodulation of the signal (91) captured by the antenna (81) under test, on the one hand, and the signal (92) which is captured by an auxiliary antenna (93) which is fixedly joined to the antenna (81) under test, that last signal (92) being considered to be the reference signal;
- the relative amplitude and phase of the signal (91) captured by the antenna under test are measured relative to the amplitude and the phase of the reference signal (92), this amplitude and this relative phase being determined, after digitisation of the two signals, by the means for processing the signal (87) of the radar and compared to theoretical reference values.

11. Method for currying out the test of an active antenna (81) during emission, according to claim 8, wherein:

- a test hyperfrequency signal and a reference signal are produced using the emission chain of the radar, the test signal being radiated inside the measuring chamber (11), via the antenna (81) under test, the test signal being obtained by transposing a test signal at intermediate frequency whose frequency is derived, by means of frequency multiplication, from a reference clock which also acts as a reference for the means for processing the signal (87) of the radar (111);
- using the reception chain of the radar, the signal (101) captured by the test probe (82) is received and demodulated,
- the amplitude deviation and phase deviation of the signal (101) captured by the antenna (81) under test is measured relative to the reference clock, the amplitude and the phase of the signal captured (101) being determined, after digitisation, using the processing means of the signal (87) of the radar (111) and compared to theoretical reference values.

12. Method for carrying out the test of an active antenna (81) during reception, according to claim 9, wherein:

- a test hyperfrequency signal and a reference signal are produced using the emission chain of the radar, the test signal being radiated inside the measuring chamber (11), via the test probe (82), the test signal being obtained by transposing a test signal at intermediate frequency whose frequency is derived, by means of frequency multiplication, from a reference clock which also acts as a reference for the means for processing the signal (87) of the radar (111);
- using the reception chain of the radar, the signal (1101) captured by the antenna (81) under test is received and demodulated,
- the amplitude deviation and phase deviation of the signal (1101) captured by the antenna (81) under test is measured relative to the reference clock, the amplitude and the phase of the signal measured being determined, after digitisation, using the processing means of the signal (87) of the radar and compared to theoretical reference values.

# Fig. 1

2-a (vue de dessus)

2-b (vue de dessus)

# Fig. 2

**Fig. 3**

**Fig. 4**

Fig. 5

Fig. 6

Fig. 7

88

881

Signal de
test

89

TRANSPOSITION
HYPER

81 Antenne
principale

Sonde
de test

883 882

86

82

Antenne
auxiliaire

Voie de
référence

R
E
C
E
P
T
E
U
R

H
Y
E
P
E
R

G
E
N
E
R
A
T
I
O
N

R
E
C
E
P
T
I
O
N

FI

T
R
A
I
T
E
M
E
N
T

Voie de
mesure

84

85

83

87

**Fig. 8**  |  Test antenne en émission

89

TRANSPOSITION
HYPER

Signal de
test

81

Antenne
principale

91

Voie de
mesure

Sonde
de test

82

Antenne
auxiliaire

92

Voie de
référence

93

R
E
C
E
P
T
E
U
R

H
Y
E
P
E
R

G
E
N
E
R
A
T
I
O
N

R
E
C
E
P
T
I
O
N

FI

T
R
A
I
T
E
M
E
N
T

85

83

87

**Fig. 9**  |  Test antenne en réception

89

Signal de
test

TRANSPOSITION
HYPER

81  Antenne
principale

Sonde
de test

Voie de
référence

R
E
C
E
P
T
E
U
R

H
Y
E
P
E
R

G
E
N
E
R
A
T
I
O
N

R
E
C
E
P
T
I
O
N

FI

T
R
A
I
T
E
M
E
N
T

82

Antenne
auxiliaire

93

1001

Voie de
mesure

85

83

87

## Fig. 10    Test antenne en émission

89

Signal de
test

TRANSPOSITION
HYPER

81  Antenne
principale

82

Voie de
mesure

R
E
C
E
P
T
E
U
R

H
Y
E
P
E
R

G
E
N
E
R
A
T
I
O
N

R
E
C
E
P
T
I
O
N

FI

T
R
A
I
T
E
M
E
N
T

Sonde
de test

1101

Antenne
auxiliaire

93

Voie de
référence

85

83

87

## Fig. 11    Test antenne en réception

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2434497